Europäisches Patentamt

(19) European Patent Office  (11) Publication number: **0 043 644**

Office européen des brevets  **B2**

(12) **NEW EUROPEAN PATENT SPECIFICATION**

(45) Date of publication of the new patent specification: 02.06.89

(51) Int. Cl.⁴: **C 23 C 14/30**, C 04 B 35/04, H 01 F 41/20, G 11 B 5/84

(21) Application number: 81302372.8

(22) Date of filling: 29.05.81

(54) **Method of making a magnetic recording medium and a ceramic crucible for such a method.**

(30) Priority: 29.05.80 JP 72304/80

(43) Date of publication of application: 13.01.82 Bulletin 82/2

(45) Publication of the grant of the patent: 05.12.84 Bulletin 84/49

(45) Mention of the opposition decision: 02.06.89 Bulletin 89/31

(84) Designated Contracting States: DE FR GB

(56) References cited:
DE-A-2 758 772
DE-B-2 632 259
GB-A-688 624

CHEMICAL ABSTRACTS, vol. 86, 1977, page 286, no. 175886w, Columbus, Ohio, USA
CHEMICAL ABSTRACTS, vol. 89, no. 22, November 1978, page 650, no. 189871m, Columbus, Ohio, USA
L.I. Maissel, Handbook of Thin Film Technology, 1970, pages 144 to 155
Brochure "Der Elektronenstrahl in der Aufdampftechnik", Leybold-Heraeus, pages 25-26
Brochure "Vakuumtechnische Tabellen und Diagramme, "Heraeus"
I.E. Campbell, "High-temperature Materials and Technology", 1967, pages 279-281
Data sheet "Werkstoff DEGUSSIT MG 25".

(73) Proprietor: **Matsushita Electric Industrial Co., Ltd.,** 1006, Oaza Kadoma, Kadoma- shi Osaka- fu, 571 (JP)

(72) Inventor: **Shinohara, Koichi, 6-8- 305 Okamoto 4-chome Higashinada- ku, Kobe- shi Hyogo- ken** (JP)

(74) Representative: **Crawford, Andrew Birkby, A.A. THORNTON & CO. Northumberland House 303-306 High Holborn, London WC1V 7LE (GB)**

EP 0 043 644 B2

## Description

This invention relates to a method of making a magnetic recording medium and more particularly relates to a method suitable for continuously depositing a ferromagnetic layer on a flexible substrate such as a plastics film.

Vacuum deposition, sputtering, ion plating, etc. have been known as methods of making a ferromagnetic thin film layer mainly composed of iron group metals. The method most practical for industrial-scale manufacturing is a vacuum deposition process employing an electron beam for heating an evaporation source material. However electron beam heating has not been fully developed yet because of its short history, so much so that continuous deposition has scarcely been achieved.

When an evaporation source material is heated by an electron beam, the temperature of the material becomes fairly high which may cause a container for the evaporation source material to be melted, whereby it is destroyed in a short time, or component materials thereof are included as impurities in the deposited ferromagnetic layer, so as to deteriorate the magnetic properties of the layer. Therefore, the material used for the container has been important.

A water-cooled copper hearth has hitherto been proposed as the container because it has a heat resistance sufficient to be able to avoid melting as mentioned above (see DE-A-2 758 772). However, in a process using a water-cooled copper hearth, the following disadvantage occurs:

In the early stages, after being melted, the source material in contact with the copper walls of the container is cooled to a temperature below the melting point of the material and so forms a deposit on the copper walls. This deposit increases in the thickness as the deposition process progresses and eventually reaches a thickness at which the surface of the deposit is scarcely subjected to the water cooling effect through the copper walls. Then the surface of the deposit begins to melt, so that the thickness thereof decreases gradually. This decrease progresses until the melted material in contact with deposit surface is cooled sufficiently to be solidified to make the deposit. Thus, such increase and decrease of the thickness of the deposit occurs cyclically, resulting in a cyclic variation of magnetic properties of the ferromagnetic layer deposited on the substrate.

It is an object of the invention to provide an improved method of continuously depositing a ferromagnetic layer on a flexible film in which the obtained layer has uniform magnetic properties.

To achieve the above-mentioned object, a method according to the invention is characterised by employing a ceramic container in place of the water-cooled copper hearth, the ceramic container having a composition comprising 97 to 99 wt.-% of MgO together with 0.2 to 0.5 wt.-% of $Al_2O_3$ and 0.4 to 1 wt.-% of $SiO_2$.

The present invention also provides an apparatus for continuously vacuum depositing a ferromagnetic layer comprising Fe, Co, Ni, or alloys thereof on a substrate, said apparatus comprising a vacuum chamber, a source of electron beam and a container for retaining and heating a ferromagnetic material source, characterised in that said container is a ceramic crucible having a composition comprising 97 to 99 wt.-% of MgO together with 0.2 to 0.5 wt.-% of $Al_2O_3$ and 0.4 to 1 wt.-% of $SiO_2$.

In order that the present invention be more readily understood, an embodiment thereof will now be described by way of example only with reference to the accompanying drawings, in which:

Figure 1 is a sectional view of an evaporation source; and

Figure 2 is a graph showing the relationship between a number of times of heat cycle is repeated and variation ratio of coercive force of deposited layers according to a previously proposed method and the method according to the preferred embodiment.

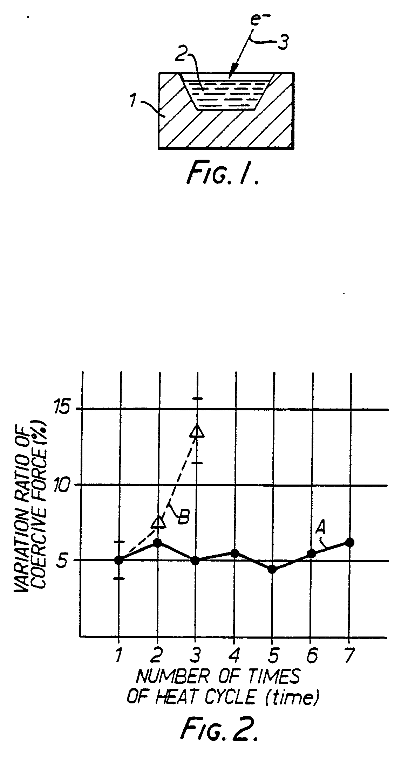

In order to find the optimum conditions for depositing a ferromagnetic layer having satisfactory magnetic properties on a moving flexible film such as a plastics film, experiments were carried out using various kinds of ceramic container 1 as shown in Figure 1. An evaporation source material 2 was charged in the container 1 and bombarded by an electron beam 3 to be raised in temperature and evaporated. Conditions of the experiments were such that the energy of an electron was 15 KeV to 60 KeV and supplied electric power was 10 kW to 140 kW. As the evaporation source material, Fe, Co, Ni, alloys thereof and those including two of three additive elements were used.

As ceramics for the containers, BeO, $ZrO_2$, MgO, $Al_2O_3$, $Si_3N_4$, BN and spinel were examined.

As for the ceramics for the container, it was found to be essential to control the contents of specified oxide materials other than the principal component in order to obtain a container capable of ensuring repeated use such as mentioned hereinafter, though the purity of the principal component has first to be controlled. We have found that MgO ceramic is most suitable for the container. It should be composed mainly of 97 % to 99 wt.-% of MgO together with 0.2 to 0.5 wt.-% of $Al_2O_3$ and 0.4 to 1 wt.-% of $SiO_2$.

When a ceramic containing a principal component other than MgO is used, various disadvantages occur such as a generation of cracks at high temperature or the formation of a spinel film covering the surface of the melted source material. This spinel film is formed due to the activity of the source material such as Fe, Co or Ni, and for example, it is composed of $CoZrO_3$ or $CaAl_2O_4$, when $ZrO_2$ or $Al_2O_3$ is used for the ceramic. The electron beam is defocused by this spinel film, whereby the evaporation rate is made unstable, resulting in a scattering of the coercive force of the deposited ferromagnetic layer.

The effect of limiting the content of $Al_2O_3$ is as follows:

If the content of $Al_2O_3$ is more than 0.5 wt.-% the spinel film as mentioned above is generated at abut 1700°C. It is disadvantageous in a practical use because a temperature of the container reaches about 1700°C when the deposition is carried out at a rate of 1 μm/sec. If the content of $Al_2O_3$ is less than 0.2 wt.-%, microcracks are generated in the wall of the container at high temperatures. The melted source material finds its way into these microcracks which cause small variations in the temperature of the melted source material. These variations are nevertheless sufficient to cause scattering of the coercive force of the deposited layer. Thus the content of $Al_2O_3$ should be from 0.2 to 0.5 wt.-%.

The effect of limiting the $SiO_2$ content is as follows:

If the content of $SiO_2$ is more than 1 wt.-%, microcracks are generated at high temperature, and so there occurs the same disadvantage such as is described above in the case of the $Al_2O_3$ content being less than 0.2 wt.-%. If the $SiO_2$ content is less than 0.4 wt.-%, the ceramic of the container becomes slightly brittle. Thus the content of $SiO_2$ should be from 0.4 to 1 wt.-%.

Using the above-mentioned container, a ferromagnetic layer is deposited, for example, in the following manner.

In a vacuum chamber, a polyethylene terephthalate film is transported along a rotary metal drum with a diameter of 1 m which is kept at a toom temperature. The chamber is kept in vacuum of $1.33 \times 10^{-3}$ Pa ($3 \times 10^{-5}$ Torr), or is supplied with oxygen gas to a pressure of $2.66 \times 10^{-3}$ Pa ($2 \times 10^{-5}$ Torr) to $6.66 \times 10^{-3}$ Pa ($5 \times 10^{-5}$ Torr). A ferromagnetic layer is deposited on a portion of film located on the peripheral surface of the drum. An evaporation source material for making the ferromagnetic layer may be Co, an alloy comprising 70 wt.-% of Co and 30 wt.-% of Ni, 75 wt.-% of Co and 25 wt.-% of Ni, 80 wt.-% of Co and 20 wt.-% of Ni, or 90 wt.-% of Co and 10 wt.-% of Ni, Fe, an alloy comprising 80 wt.-% of Co and 20 wt.-% of Cr, or 85 wt.-% of Co and 15 wt.-% of Cr. The ferromagnetic layer is deposited to a thickness from 0.1 to 0.2 μm. Thus a magnetic recording medium having a coercive force from 600 Oe to 1200 Oe is obtained.

Fig. 2 shows the relationship between a number of times the ceramic container is heat cycled by repeated use and the variation ratio of a coercive force of the deposited ferromagnetic layer. The relationships are shown for the cases of containers according to the present invention and that previously proposed. The former case is denoted by the letter A and the latter by the letter B. These data was obtained by performing depositions of Fe, Co, Ni, Fe-Ni alloys, Co-Ni alloy or Co-Fe alloy at deposition rates from 30 g/min to 500 g/min, with the amount of melted source material being from 5 kg to 30 kg on average. The variation ratio is expressed by a value measured on a deposition length of 1000 m.

As seen from Fig. 2, the container according to the invention can provide with a uniform property of the deposited layer even after repeated use.

## Claims

1. A method of making a magnetic recording medium including the step of continuously vacuum depositing a ferromagnetic layer comprising Fe, Co, Ni or alloys thereof on a substrate using an electron beam for heating an evaporation source material in a container characterised in that the container for retaining said source material in a heating position is made of a ceramic having a composition comprising 97 to 99 wt.-% of MgO, together with 0.2 to 0.5 wt.-% of $Al_2O_3$ and 0.4 to 1 wt.-% of $SiO_2$.

2. A method of making a magnetic recording medium as claimed in claim 1, wherein the deposition rate of the ferromagnetic layer is between 30 g/min and 500 g/min.

3. An apparatus for continuously vacuum depositing a ferromagnetic layer comprising Fe, Co, Ni, or alloys thereof on a substrate, said apparatus comprising a vacuum chamber, a source of electron beam and a container for retaining and heating a ferromagnetic material source, characterised in that said container is a ceramic crucible having a composition comprising 97 to 99 wt.-% of MgO together with 0.2 to 0.5 wt.-% of $Al_2O_3$ and 0.4 to 1 wt.-% of $SiO_2$.

## Patentansprüche

1. Verfahren zur Herstellung eines magnetischen Aufzeichnungsmediums, bei welchem eine ferromagnetische Schicht, die Fe, Co, Ni oder Legierungen davon umfaßt, auf enem Substrat unter Verwendung eines Elektronenstrahls zum Erhitzen eines Verdampfungsausgangsmaterials in einem Behälter kontinuierlich im Vakuum abgeschieden wird,

dadurch gekennzeichnet,

daß der Behälter zum Halten des Ausgangsmaterials in einer Erwärmungsposition aus einem keramischen haterial mit einer Zusammensetzung, die 97 bis 99 Gew.-% MgO, zusammen mit 0,2 bis 0,5 Gew.-% $Al_2O_3$ und 0,4 bis 1 Gew.-% $SiO_2$ umfaßt, hergestellt ist.

2. Verfahren zur Herstellung eines magnetischen Aufzeichnungsmediums nach Anspruch 1, worin die Abscheidungsgeschwindigkeit der ferromagnetischen Schicht zwischen 30 g/min und 500 g/min liegt.

3. Vorrichtung zur kontinuierlichen Vakuumabscheidung einer ferromagnetischen Schicht, die Fe, Co, Ni oder Legierungen davon umfaßt, auf einem Substrat, wobei die Vorrichtung eine Vakuumkammer, eine Elektronenstrahlquelle und einen Behälter zur Aufnahme und Erwärmung eines ferromagnetischen Ausgangsmaterials umfaßt,

dadurch gekennzeichnet,

daß der Behälter ein keramischer Tiegel mit einer Zusammensetzung, die 97 bis 99 Gew.-% MgO, zusammen mit 0,2 bis 0,5 Gew.-% $Al_2O_3$ und 0,4 bis 1 Gew.-% $SiO_2$ umfaßt, ist.

**Revendications**

1. Procédé de fabrication d'un support d'enregistrement magnétique comprenant l'étape de dépôt continu sous vide d'une couche ferromagnétique comprenant du Fe, Co, Ni ou leurs alliages sur un substrat à l'aide d'un faisceau électronique servant à chauffer le matériau d'une source d'évaporation se trouvant dans un conteneur, caractérisé en ce que le conteneur destiné à retenir ledit matériau de la source dans une position de chauffage est fait d'une céramique ayant la composition suivante: de 97 à 99 %, en poids, de MgO, ainsi que de 0,2 à 0,5 %, en poids, de $Al_2O_3$ et de 0,4 à 1 %, en poids, de $SiO_2$.

2. Procédé de fabrication d'un support d'enregistrement magnétique selon la revendication 1, selon lequel la vitesse de dépôt de la couche ferromagnétique est comprise entre 30 g/min et 500 g/min.

3. Appareil pour effectuer le dépôt continu sous vide d'une couche ferromagnétique comprenant du Fe, Co, Ni ou leurs alliages sur un substrat, ledit appareil comprenant une chambre à vide, une source de faisceau électronique et un conteneur destiné à retenir et à chauffer une source de matériau ferromagnétique, caractérisé en ce que ledit conteneur est un creuset de céramique ayant la composition suivante: de 97 à 99 %, en poids, de MgO, ainsi que de 0,2 à 0,5 %, en poids, de $Al_2O_3$ et de 0,4 à 1 %, en poids, de $SiO_2$.

FIG. 1.

FIG. 2.